# EUROPEAN PATENT SPECIFICATION

(11) **EP 4 040 681 B1**
(45) Date of publication and mention of the grant of the patent: **14.10.2026**
(21) Application number: 21167799.2
(22) Date of filing: 12.04.2021
(51) Int. Cl.: H03K 17/96, H01H 23/04, H01R 13/514, H05B 47/10, H02G 3/10

(54) **IMPROVED SWITCH DEVICE**
VERBESSERTE SCHALTVORRICHTUNG
DISPOSITIF DE COMMUTATION AMÉLIORÉ

(30) Priority: 04.02.2021 IT 202100002492
(43) Date of publication of application: 10.08.2022
(73) Proprietor: Iotty Srl, 33080 Porcia (PN) (IT)
(72) Inventor: BACCHIN, Alberto, 33080 PORCIA (IT); CESARI, Edoardo, 33080 PORCIA (IT)
(74) Representative: Rocchetto, Elena

(56) References cited:
- EP-A1- 3 352 065
- WO-A1-2017/134646
- US-A1- 2017 111 085
- US-A1- 2019 120 471

## Description

This patent relates to switch devices, present in all types of buildings, for both civil and industrial use, for switching on/off indoor or outdoor lights, for electrical sockets, for thermostats, for the opening/closing of doors, gates, curtains and shutters or for other electrical equipment for civil or industrial use.

The prior art includes various types of electro-mechanical switch devices, and more recently they are also equipped with various types of sensors, such as touch screen sensors, which enable the switching on and off of lights or electrical/electronic equipment in general, as well as the opening and closing of doors, gates, curtains, shutters and other devices.

Said switch devices equipped with suitable sensors may have a single switch on one plate or may be placed in groups of two or three or more on a single plate and may include backlighting systems in order to help the user to identify the switch to be used.

Said switch devices are commonly installed on a plate supporting the switch modules and coupling for the external plate.

Each plate will support a certain number of switches, for example three, where each of said switches will be able to open and close a circuit relating to a specific lighting body or specific electrical equipment.

Capacitive touch-controlled on/off devices are known in the prior art and comprise an external plate on which there are areas sensitive to the contact of human fingers or other conductive bodies that activate the switches in such a way that the simple contact with those areas causes the opening/closing of the circuits connected to them.

One drawback of the switch devices in the prior art, whether they are electromechanical or electronic, is that they have a limited number of possible functions and, once designed, can no longer be modified.

For example, a switch device configured to house two switching modules, thus corresponding to two functions, can no longer be modified into a device with three power and switching modules or three functions.

Consequently, the manufacturers of such devices must provide for a variety of housing elements, front and external plates, resulting in higher production costs and a greater need for storage space.

Patents 102018000007451 and 102018000007149 filed by the same applicant concern switch devices comprising a box-shaped body intended to be fixed to a flush-mounted box, said body being equipped at the front with a front plate on which there are touch sensors or contacts in general, in turn connected to a main electronic control circuit.

An example of a switch device according to the preamble of claim 1 is disclosed in US 2019/120471 A1.

In the position opposite to said front plate, that is, on the back of the box-shaped body, there are connectors for the electrical/electronic connection with connection cables to the electrical system of the building and to the equipment that must be controlled by the switch device.

At least one external plate is mounted on said front plate, which may in turn comprise one or more capacitive touch contact areas, each connected to one of said contacts.

Said switches may also comprise one or more lighting devices connected to said main electronic control circuit and mounted in a position behind said external plate, which in turn comprises one or more transparent areas.

This patent relates to a new type of switch device with expandable functions and a new accessory to expand the functions, which can be installed on the switch device.

The main object of the present invention is to extend the functions of a switch device without having to structurally modify the switch device itself.

This object is obtained by a switch device according to independent claim 1. Further preferred embodiments are defined in the dependent claims.

One advantage of the present invention is that it provides a main base module configured in a pre-established and invariable version, and an accessory module which can be selectively connected to said main standard module in order to extend its functions if needed.

The new switch device comprises a main base module, in turn comprising an electronic control circuit and a main box-shaped body intended to be connected directly or indirectly to a flush-mounted box or to a support in general for switching devices.

Said body comprises a front plate on which there are one or more touch sensors or contacts in general, connected to said main electronic control circuit.

Said main module also comprises, preferably in the position opposite to said front plate, that is, on the rear wall of said box-shaped body, connectors for the electrical/electronic connection of cables connecting to the electrical system and to the equipment to be controlled by the main module.

At least one external plate is conveniently mounted on said front plate which in turn may only function as a cover or preferably may be of the type described in patent 102018000007451 or 102018000007149, that is, comprising in turn one or more capacitive touch contact areas.

Said main module may also comprise one or more lighting devices mounted in a position behind said external plate, for example directly or indirectly mounted on said front plate or on said body in general as well as means for selectively turning on/off one or more of said lighting devices. Said lighting devices are, for example, connected to said main electronic circuit.

Said at least one external plate will conveniently comprise one or more transparent areas or in any case suitable to allow the light emitted by said illuminating devices to pass.

Said main module may also comprise one or more remote communication devices, for communication with a remote electronic device, for example a mobile phone in use by a user, which can communicate remotely with said main electronic control circuit and thus control its related functions.

Said main module further comprises at least one electronic connection port, to connect said main electronic circuit to at least one secondary electronic circuit.

Said at least one secondary electronic circuit is housed in a second module, hereinafter called accessory module, in turn comprising a body suited to house said at least one secondary circuit and means for the electronic connection of said at least one secondary circuit to said main electronic command circuit of said main module.

Said main module and said accessory module also comprise means for reciprocal mechanical connection, of the reversible type Said main module comprises an opening or seat made on said main body for the insertion of said connection means of the accessory module, which in turn preferably consist of connectors which also provide the electronic connection.

Said opening is located on the rear side of said body of the main module, that is, on the side opposite said front plate.

Said accessory module may also comprise further connections such as, for example, input connections, output connections, etc.

The installation of the accessory module enables the expansion of the functions of the main module, the main electronic control circuit of which can therefore control not only the functions and equipment connected to said main module, but also the functions and equipment connected to said accessory module.

The characteristics of the new switch and accessory will be better clarified by the following description with reference to the drawings, attached by way of a non-limiting example.
Figure 1 shows a schematic side view of the new switch device (100) in a first embodiment, where a main module (1) and an accessory module (2) not connected to the main module (1) are visible.
Figure 1a shows a schematic front view of the switch device (100) of Figure 1, while Figure 1b shows a side view of the switch device (100) where the accessory module (2) is mechanically and electronically connected to the main module (1).
Figure 2 shows a schematic side view of the new switch device (100') in a second embodiment, where a main module (1) and an accessory module (2') not connected to the main module (1) are visible.
Figure 2a shows a schematic front view of the switch device (100') of Figure 2, while Figure 2b shows a side view of the switch device (100') where the accessory module (2') is mechanically and electronically connected to the main module (1).

The new switch device (100) comprises a main module (1), in turn comprising a main electronic control circuit, housed in a main box-shaped body (12) intended to be connected directly or indirectly to a flush-mounted box or to a support in general for switches.

Said main body (12) comprises a front plate (11) on which there are touch sensors or contacts in general.

At least one external plate (3) is suitably mounted on said front plate (11) comprising in turn one or more capacitive touch contact areas (31, 32).

Said main module (1) comprises suitable connections (14) for the electrical/electronic connection with various possible devices which will be controlled by the new switch device.

Said main module (1) also comprises at least one connection port (13) to electronically connect said main electronic control circuit to a second secondary circuit of an accessory module (2).

Said accessory module (2) in turn comprises a housing element (21) of a secondary electronic circuit, means (22) for the electrical/electronic connection of said secondary circuits and/or of said switching modules to said main electronic circuit and means (23) for the mechanical connection of said accessory module (2) to said main body (12) of the main module (1).

For example, said body (12) of said main module (1) suitably comprises at least one opening or seat (13) for the engagement of said mechanical connection means (23) and for the insertion of said electronic connection means (22) of said accessory module (2).

Said opening (13) is located on the rear side of said box-shaped body (12) of said main module (1), that is, on the side opposite said front plate (11).

Said mechanical connection means (23) of the accessory module (2) allow the reversible mechanical connection of said accessory module (2) to said main module (1).

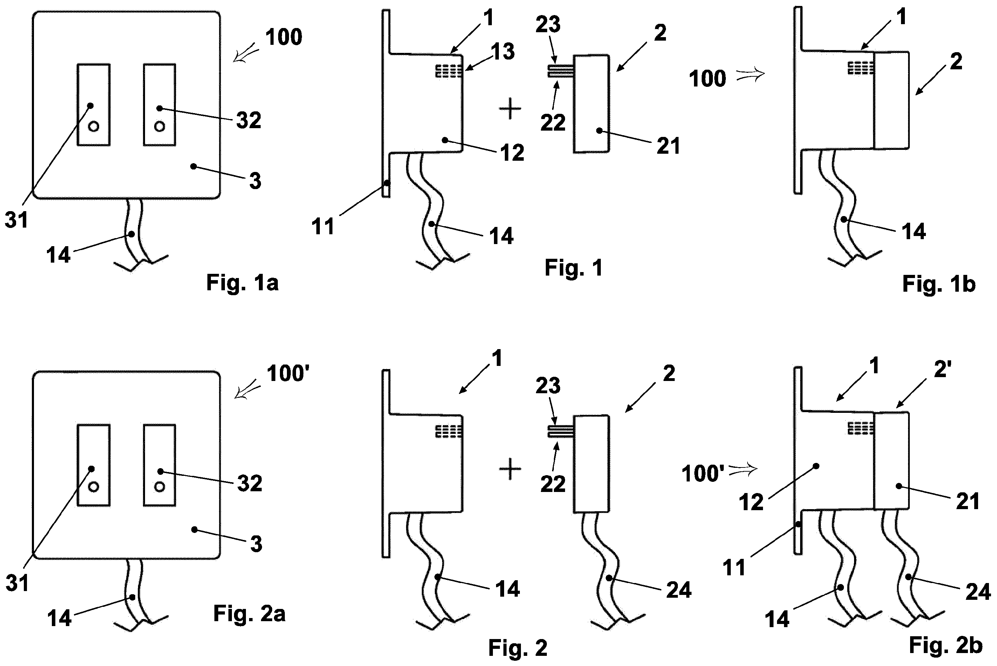

The use of said accessory module (2) enables the expansion of the functions of the main module (1) which can therefore control not only the functions connected to it but also the functions connected to the accessory module (2). In the embodiment shown in Figure 2, said accessory module (2) may also comprise further connections (24) such as, for example, input connections, output connections, etc.

In both embodiments described above, said accessory module (2) may also comprise devices for remote communication with other electronic devices, for example mobile phones in use by a user, and/or one or more sound emission and/or reception devices, which can be activated remotely or through said connections (24).

Therefore, with reference to the preceding description and the attached drawings the following claims are expressed.

## Claims

1. Switch device (100) comprising a main module (1), comprising at least one main electronic control circuit, connections (14) for the electrical/electronical connection to the electrical system of a building and/or to equipment/devices to be controlled, one or more touch sensors or contacts connected to said at least one main electronic control circuit, a main box-shaped body (12) to house said main electronic control circuit and said one or more touch sensors or contacts wherein said main module (1) further comprises:
- at least one further port or opening or seat (13) for the reversible electrical/electronic connection of said main electronic control circuit with at least one further secondary electronic circuit;
- means for the reversible mechanical connection with a housing element (21) of said at least one secondary electronic circuit,
and wherein said switch device (100) also comprises at least one accessory module (2) comprising:
- a housing element (21) for said at least one secondary electronic circuit,
- said at least one secondary electronic circuit;
- means (22) for the electrical/electronic connection of said at least one secondary electronic circuit with said main electronic circuit of said main module (1),
- means (23) for the mechanical connection of said housing element (21) of said accessory module (2) to said main box-shaped body (12) of said main module (1),
and wherein said main body (12) of said main module (1) comprises a front plate (11) where said one or more touch sensors or contacts are located and
**characterized in that**
said at least one port or opening or seat (13) for the engagement of said mechanical connection means (23) and for the insertion of said electronic connection means (22) of said accessory module (2) is located on the rear side of said box-shaped body (12) of said main module (1), that is, on the side opposite said front plate (11).

2. Switch device (100) according to claim 1, **characterized in that** said accessory module (2) comprises one or more further electrical/electronic connection means (24) with external devices/equipment.

3. Switch device (100) according to one of the preceding claims, **characterized in that** it comprises one or more devices for remote communication.

4. Switch device (100) according to one or more of the preceding claims, **characterized in that** it comprises one or more sound emitting and/or receiving devices in said main module (1) and/or in said accessory module (2).

5. Switch device (100) according to one or more of the preceding claims, **characterized in that** it comprises one or more lighting devices in said main module (1) and/or in said accessory module (2).

## Patentansprüche

1. Schaltvorrichtung (100) umfassend ein Hauptmodul (1), das Folgendes umfasst:
mindestens eine elektronische Hauptsteuerschaltung, Verbindungen (14) für die elektrische/elektronische Verbindung mit dem elektrischen System eines Gebäudes und/oder mit zu steuernden Geräten/Vorrichtungen, einen oder mehrere Berührungssensoren oder Kontakte, die mit der besagten mindestens einen elektronischen Hauptsteuerschaltung verbunden sind, einen kastenförmigen Hauptkörper (12) zum Aufnehmen der besagten elektronischen Hauptsteuerschaltung und des besagten einen oder der besagten mehreren Berührungssensoren oder Kontakte, wobei das besagte Hauptmodul (1) ferner Folgendes umfasst:
- mindestens einen weiteren Anschluss, eine weitere Öffnung oder einen weiteren Sitz (13) für die reversible elektrische/elektronische Verbindung der besagten elektronischen Hauptsteuerschaltung mit mindestens einer weiteren elektronischen Nebenschaltung;
- Mittel für die reversible mechanische Verbindung mit einem Aufnahmeelement (21) der besagten mindestens einen elektronischen Nebenschaltung,
und wobei die besagte Schaltvorrichtung (100) ferner mindestens ein Zubehörmodul (2) umfasst, das Folgendes umfasst:
- ein Aufnahmeelement (21) für die besagte mindestens eine elektronische Nebenschaltung;
- die besagte mindestens eine elektronische Nebenschaltung;
- Mittel (22) für die elektrische/elektronische Verbindung der besagten mindestens einen elektronischen Nebenschaltung mit der besagten elektronischen Hauptschaltung des besagten Hauptmoduls (1);
- Mittel (23) für die mechanische Verbindung des besagten Aufnahmeelements (21) des besagten Zubehörmoduls (2) mit dem besagten kastenförmigen Hauptkörper (12) des besagten Hauptmoduls (1),
und wobei der besagte Hauptkörper (12) des besagten Hauptmoduls (1) eine Frontplatte (11) umfasst, auf der sich der besagte eine oder die besagten mehreren Berührungssensoren oder
Kontakte befinden, und **dadurch gekennzeichnet, dass** sich der besagte mindestens eine Anschluss, die besagte mindestens eine Öffnung oder der besagte mindestens eine Sitz (13) zum Eingriff der besagten mechanischen Verbindungsmittel (23) und zum Einsetzen der besagten elektronischen Verbindungsmittel (22) des besagten Zubehörmoduls (2) auf der Rückseite des besagten kastenförmigen Körpers (12) des besagten Hauptmoduls (1) befindet, das heißt auf der der besagten Frontplatte (11) gegenüberliegenden Seite.

2. Schaltvorrichtung (100) nach Patentanspruch 1, **dadurch gekennzeichnet, dass** das besagte Zubehörmodul (2) ein weiteres elektrisches/elektronisches Verbindungsmittel oder mehrere weitere elektrische/elektronische Verbindungsmittel (24) mit externen Vorrichtungen/Geräten umfasst.

3. Schaltvorrichtung (100) nach einem der vorhergehenden Patentansprüche, **dadurch gekennzeichnet, dass** sie eine oder mehrere Vorrichtungen für die Fernkommunikation umfasst.

4. Schaltvorrichtung (100) nach einem oder mehreren der vorhergehenden Patentansprüche, **dadurch gekennzeichnet, dass** sie eine oder mehrere schallabgebende und/oder -empfangende Vorrichtungen im besagten Hauptmodul (1) und/oder im besagten Zubehörmodul (2) umfasst.

5. Schaltvorrichtung (100) nach einem oder mehreren der vorhergehenden Patentansprüche, **dadurch gekennzeichnet, dass** sie eine oder mehrere Beleuchtungsvorrichtungen im besagten Hauptmodul (1) und/oder im besagten Zubehörmodul (2) umfasst.

## Revendications

1. Dispositif de commutation (100) comprenant un module principal (1), comprenant au moins un circuit électronique de commande principal, des connexions (14) pour la connexion électrique/électronique au système électrique d'un bâtiment et/ou à des équipements/appareils à commander, un ou plusieurs capteurs tactiles ou contacts reliés audit au moins un circuit électronique de commande principal, un corps principal en forme de boîtier (12) destiné à loger ledit circuit électronique de commande principal et ledit un ou plusieurs capteurs tactiles ou contacts, où ledit module principal (1) comprend en outre :
- au moins un autre port, ouverture ou logement (13) destiné à la connexion électrique/électronique réversible dudit circuit électronique de commande principal avec au moins un autre circuit électronique secondaire ;
- des moyens permettant la connexion mécanique réversible avec un élément de logement (21) dudit au moins un circuit électronique secondaire,
et où ledit dispositif de commutation (100) comprend également au moins un module accessoire (2) comprenant :
- un élément de logement (21) destiné audit au moins un circuit électronique secondaire,
- ledit au moins un circuit électronique secondaire ;
- des moyens (22) destinés à la connexion électrique/électronique dudit au moins un circuit électronique secondaire avec ledit circuit électronique principal dudit module principal (1),
- des moyens (23) pour la connexion mécanique dudit élément de logement (21) dudit module accessoire (2) audit corps principal en forme de boîtier (12) dudit module principal (1),
et où ledit corps principal (12) dudit module principal (1) comprend une plaque avant (11) sur laquelle sont situés ledit un ou plusieurs capteurs tactiles ou contacts, et **caractérisé en ce que** ledit au moins un port, ouverture ou logement (13) destiné à recevoir lesdits moyens de connexion mécanique (23) et pour l'insertion desdits moyens de connexion électroniques (22) dudit module accessoire (2) est situé sur la face arrière dudit corps en forme de boîtier (12) dudit module principal (1), c'est-à-dire sur le côté opposé à ladite plaque avant (11).

2. Dispositif de commutation (100) selon la revendication 1, **caractérisé en ce que** ledit module accessoire (2) comprend un ou plusieurs moyens de connexion électriques/électroniques supplémentaires (24) avec des dispositifs/équipements externes.

3. Dispositif de commutation (100) selon l'une des revendications précédentes, **caractérisé en ce qu'**il comprend un ou plusieurs dispositifs de communication à distance.

4. Dispositif de commutation (100) selon une ou plusieurs des revendications précédentes, **caractérisé en ce qu'**il comprend un ou plusieurs dispositifs d'émission et/ou de réception sonore dans ledit module principal (1) et/ou dans ledit module accessoire (2).

5. Dispositif de commutation (100) selon l'une ou plusieurs des revendications précédentes, **caractérisé en ce qu'**il comprend un ou plusieurs dispositifs d'éclairage dans ledit module principal (1) et/ou dans ledit module accessoire (2).
